# EUROPÄISCHE PATENTSCHRIFT

(11) **EP 1 002 363 B1**
(45) Veröffentlichungstag und Bekanntmachung des Hinweises auf die Patenterteilung: **06.11.2002**
(21) Anmeldenummer: 98941411.5
(22) Anmeldetag: 11.08.1998
(51) Int. Cl.: H03F 3/08, H03F 1/30

(54) **VORRICHTUNG ZUM UMSETZEN KLEINER, VON EINER NICHT-IDEALEN STROMQUELLE AN DEM EINGANG DER VORRICHTUNG EINGEPRÄGTER STRÖME IN SPANNUNGSSIGNALE**
DEVICE FOR TRANSFORMING INTO VOLTAGE SIGNALS WEAK ELECTRIC CURRENTS IMPRESSED BY A NON-IDEAL ELECTRIC CURRENT SOURCE AT THE INLET OF SAME DEVICE
DISPOSITIF POUR TRANSFORMER EN SIGNAUX DE TENSION, DE FAIBLES INTENSITES APPLIQUEES PAR UNE SOURCE DE COURANT NON IDEALE A L'ENTREE DE CE DISPOSITIF

(30) Priorität: 12.08.1997 DE 19734760
(43) Veröffentlichungstag der Anmeldung: 24.05.2000
(73) Patentinhaber: WOLTER, Klaus, D-40625 Düsseldorf (DE); HENKE, Dieter, D-40625 Düsseldorf (DE)
(72) Erfinder: WOLTER, Klaus, D-40625 Düsseldorf (DE); HENKE, Dieter, D-40625 Düsseldorf (DE)
(74) Vertreter: Schippan, Ralph, Dr.-Ing.
(86) Internationale Anmeldenummer: EP9805082
(87) Internationale Veröffentlichungsnummer: WO99008377

(56) Entgegenhaltungen:
- US-A- 4 939 475
- US-A- 5 592 124
- PATENT ABSTRACTS OF JAPAN vol. 096, no. 004, 30. April 1996 & JP 07 321565 A (SONY CORP), 8. Dezember 1995
- CENNINI P ET AL: "A WIDEBAND BIPOLAR TRANSIMPEDANCE PREAMPLIFIER FOR OPTICAL RECEIVER" NUCLEAR INSTRUMENTS & METHODS IN PHYSICS RESEARCH, SECTION - A: ACCELERATORS, SPECTROMETERS, DETECTORS AND ASSOCIATED EQUIPMENT, Bd. A317, Nr. 1/02, 15. Juni 1992, Seiten 308-312, XP000413063

## Beschreibung

Die Erfindung betrifft eine Vorrichtung zum Umsetzen kleiner, von einer nicht-idealen Stromquelle an dem Eingang der Vorrichtung eingeprägter Ströme in Spannungssignale, enthaltend einen Umsetzer zum Wandeln der kleinen Ströme in Spannungssignale.

Vorrichtungen zum Umsetzen kleiner Stromsignale in Spannungssignale sind aus der Praxis bekannt, so beispielsweise auch aus Hewlett Packard: "Optoelectronics Designer's Catalog", U.S.A. 5091-4573E (6/93) Seiten 5-32;5-36; 5-66; 5-123. In diesem Dokument sind verschiedene Schaltungen dargestellt, mit denen Stromsignale, die von einer aus einer Photodiode bestehenden Stromquelle zur Verfügung gestellt werden, in Spannungssignale für die Weiterverwendung umgewandelt werden können.

Die Druckschrift US 4,939,475 beschreibt ebenfalls eine Schaltung mit optoelektrischem Umsetzer. Die vorgeschlagene Schaltung umfaßt dabei einen in seiner Verstärkung einstellbaren Verstärker, an dessen Eingang eine Photodiode angeschlossen ist und der über mehrere zueinander parallelgeschaltete Rückkopplungszweige rückgekoppelt ist.

Mit den von Signalstromquellen mit nicht-idealen Komponenten gelieferten Strömen sind jedoch Spannungen, die den Anforderungen bestimmter Anwendungen genügen, durch eine Strom-Spannungswandlung ohne weitere Aufbereitung nicht zu erzeugen. Des weiteren haben die Ströme von eventuell eingesetzten zusätzlichen Schaltungselementen, die für die Steuerung der Vorrichtung verwendet werden, einen störenden Einfluß auf das ausgegebene Spannungssignal.

Der Erfindung liegt die Aufgabe zugrunde, eine Vorrichtung zu schaffen, mit der eine Umsetzung kleiner, von einer Stromquelle mit nicht-idealen Komponenten gelieferter Stromsignale in Spannungssignale möglich ist, bei der sich die nicht-idealen Komponenten der Stromquelle weitgehend nicht auf das Nutzsignal auswirken und gleichzeitig ein störender Einfluß von für die Steuerung der Schaltung eingesetzten weiteren Strömen minimiert wird.

Die Aufgabe wird erfindungsgemäß bei einer Vorrichtung der eingangs genannten Art dadurch gelöst, daß der Ausgang des Umsetzers über mindestens einen Rückkoppelzweig und einen Ankoppler auf den Eingang des Umsetzers rückgekoppelt ist, wobei der Ankoppler so geschaltet ist, daß von dem mindestens einen Rückkoppelzweig gelieferte Steuerströme zur Steuerung der kleinen, von der nicht idealen Stromquelle an dem Eingang der Vorrichtung eingeprägten Ströme an dem Eingang des Umsetzers mittels des Ankopplers unter einer Minderung des kapazitiven, induktiven und ohmschen Einflusses der Rückkoppelzweige sowie einer Amplitudenanpassung der Steuerströme einkoppelbar sind.

Ein Vorteil der erfindungsgemäßen Vorrichtung besteht darin, daß durch die Rückkopplung des Ausgangssignal der Vorrichtung auf den Eingang über den Ankoppler der Einfluß der nicht-idealen Komponenten der Stromquelle auf den Signalstrom kompensiert werden kann. Die Ströme der Rückkoppelzweige werden, soweit vorhanden, durch Ankopplung direkt auf den Eingang geschaltet. Der Ankoppler ist dabei so ausgebildet, daß der von der Stromquelle kommende Strom von den Steuerströmen der Rückkoppelzweige gesteuert auf den Eingang der Vorrichtung gegeben werden kann. Durch die Verstärkungsfunktion des Ankopplers mit einem Verstärkungsfaktor kleiner 1 sind insbesondere große Steuerströme, eine leichtere Handhabung und größere Toleranzen bei den eingesetzten Bauteilen möglich.

In einer bevorzugten Ausführungsform umfaßt der Umsetzer einen Stromverstärker und Impedanzwandler sowie einen Spannungsvertärker. Vorteilhafterweise umfaßt dann einer der Rückkoppelzweige der Vorrichtung einen Verstärkungsrückkoppler zur Einstellung der Verstärkung des Spannungsverstärkers und zur Kompensation von Auswirkungen nicht-idealer Komponenten der Stromquelle im Eingangsstrom. Mit einem solchen Verstärkungsrückkoppler können parasitäre Einflußgrößen des Rückkoppelzweiges minimiert werden. Ebenso kann durch ein zur Verfügungstellen eines Kompensationsstroms durch den Verstärkungsrückkoppler der Spannungshub am Eingang der Vorrichtung minimiert werden.

Ebenfalls vorteilhaft ist eine Ausführungsform, die einen Arbeitspunkteinsteller/ Temperaturdriftkompensator in einem der Rückkoppelzweige vorsieht, der eine Einstellung des Arbeitspunktes der Vorrichtung mit Temperaturdriftkompensation ermöglicht. Auf diese Weise kann nicht nur ein nutzsignalunabhängiger, statischer Arbeitspunkt einmalig eingestellt, sondern kontinuierlich die durch Temperaturänderungen hervorgerufene Drift des Arbeitspunktes ausgeglichen werden, die aus der Temperaturabhängigkeit der eingesetzten Bauteile herrührt.

Eine weitere vorteilhafte Ausgestaltung der erfindungsgemäßen Vorrichtung weist in einem der Rückkoppelzweige einen Signalhubbegrenzer zur Reduzierung der Verstärkung der Vorrichtung und zur Begrenzung des Signalhubs am Eingang der Vorrichtung auf. Dabei ist die Schwelle für den Einsatz der Wirkung des Signalhubbegrenzers so festgelegt, daß sie später als der Verstärkungsrückkoppler einsetzt. Mit einer Begrenzung des Signalhubs wird eine Übersteuerung der Vorrichtung vermieden, und mit der Begrenzung der Verstärkung werden die Auswirkungen der nicht idealen Komponenten der Signalstromquelle minimiert.

Ein Anschluß der nicht-idealen Stromquelle kann auf das Potential des EMV Schirmes gelegt werden.

Die erfindungsgemäße Vorrichtung läßt sich durch einige Ergänzungen besonders vorteilhaft für "10 Base T"-, "100 Base T"- oder Gigabase-Anwendungen einsetzen.

Neben den notwendigen Ergänzungen, die zum Erhalt des für "10 Base T"-Anwendungen erforderlichen Differenzstromsignals durchgeführt werden müssen, ist es bei einer Anpassung an "10 Base T"-Anwendungen auch möglich, eine Anschlußeinheit als Schnittstelle vorzusehen, die ein einfaches Wechseln zwischen PC und Netzverteiler durch Umstecken erlaubt. Des weiteren kann durch entsprechende Beschaltung der Anschlüsse der Anschlußeinheit die Notwendigkeit für einen zusätzlichen Versorgungsanschluß vermieden werden, wenn die Versorgungsspannung über die jeweils für die Differenzstromsignale für die "10 Base T"-Anwendung nicht genutzte Steckverbindung der erfindungsgemäßen Vorrichtung zur Verfügung gestellt wird.

Aber auch ein Einsatz für andere Anwendungen, wie Profibus, Interbus etc., ist durch Ergänzungen entsprechend der Anforderungen der jeweiligen Anwendung möglich.

Weitere vorteilhafte Ausgestaltungen der Erfindung gehen aus den Unteransprüchen hervor.

Die Erfindung wird im folgenden anhand von Ausführungsbeispielen unter Bezugnahme auf Zeichnungen näher erläutert. Dabei zeigt
- Fig. 1:: ein Blockschaltbild eines ersten Ausführungsbeispiels gemäß Erfindung;
- Fig. 2:: eine bevorzugte schaltungstechnische Realisierung des Ausführungsbeispiels aus Figur 1;
- Fig. 3:: ein Blockschaltbild eines zweiten Ausführungsbeispiels gemäß Erfindung; und
- Fig. 4-7:: schaltungstechnische Realisierungsmöglichkeiten der einzelnen über das erste Ausführungsbeispiel hinaus gehenden Funktionsblöcke des zweiten Ausführungsbeispiels aus Figur 3.

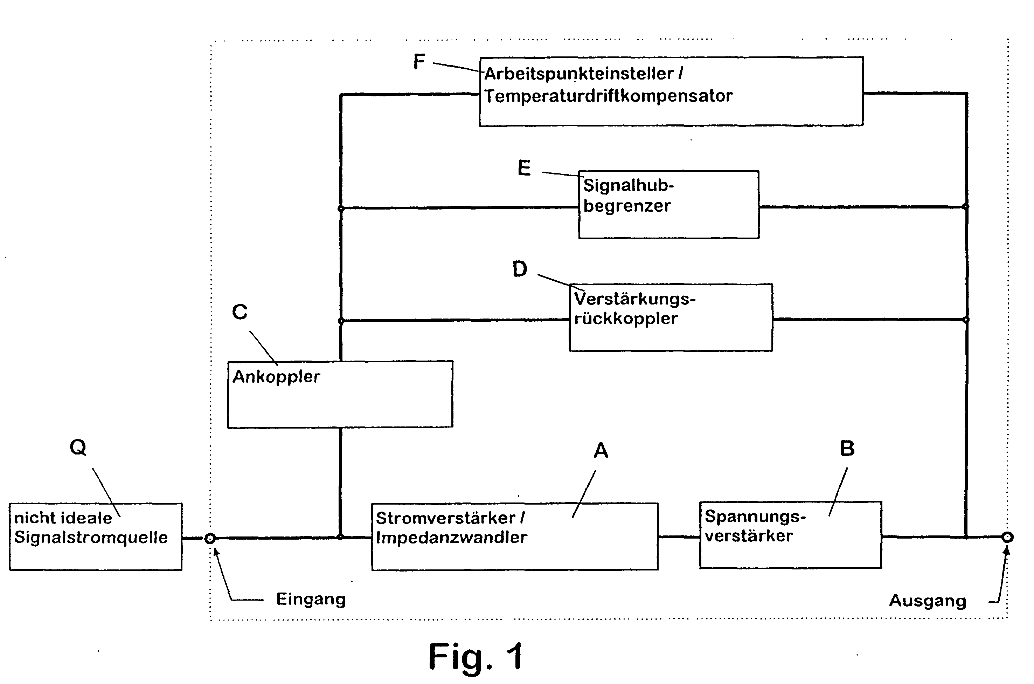

In Figur 1 ist ein Blockschaltbild einer Vorrichtung zum Umsetzen kleiner Stromsignale in Spannungssignale dargestellt, die an ihrem Eingang mit einer nicht-idealen Signalstromquelle Q verbunden ist.

Zwischen den Eingang und den Ausgang der Vorrichtung sind hintereinander ein Stromverstärker und Impedanzwandler A und ein Spannungsverstärker B geschaltet. Von dem Ausgang des Spannungsverstärkers B erfolgt eine Rückkopplung zu dem Eingang des Stromverstärkers und Impedanzwandlers A über drei zueinander parallele Funktionsblöcke: Zum einen über einen Verstärkungsrückkoppler D, zum anderen über einen Signalhubbegrenzer E und schließlich über einen Arbeitspunkteinsteller/Temperaturdriftkompensator F. Alle drei Funktionsblöcke D,E,F sind über einen gemeinsamen Ankoppler C mit dem Eingang des Stromverstärkers und Impedanzwandlers A verbunden.

Die Stromquelle Q liefert der Vorrichtung einen kleinen, nicht-idealen Signalstrom. Der Signalstrom wird anschließend von dem Stromverstärker und Impedanzwandler A verstärkt und an die Eingangsimpedanz des folgenden Spannungsverstärkers B angepaßt.

Der Spannungsverstärker B seinerseits, der invertierend ausgeführt ist, setzt das Stromsignal in ein Spannungssignal um.

Der Verstärkungsrückkoppler D regelt über seine Stromleitfähigkeit die Verstärkung des stromgespeisten Spannungsverstärkers B. Er erhält als Eingangssignal das Ausgangssignal des Spannungsverstärkers B, wobei das eingegebene Signal so zu einem Steuerstrom aufbereitet und über den Ankoppler der Steuerströme C auf den Eingang zurückgekoppelt wird, daß parasitäre Einflußgrößen des Rückkoppelzweiges minimiert werden.

Gleichzeitig kann der Gleichgewichtszustand der Vorrichtung auch bei nicht-konstantem Eingangssignal dynamisch aufrechterhalten werden. Durch die Verkettung von Stromverstärker und Impedanzwandler A, Spannungsverstärker B, Verstärkungsrückkoppler D und Ankoppler C kann am Eingang der Vorrichtung ein Kompensationsstrom zur Verfügung gestellt werden. Dadurch wird es möglich, den Spannungshub bei einem anliegenden Signalstrom der Signalstromquelle Q am Eingang der Vorrichtung so zu minimieren, daß nicht ideale Komponenten der Signalstromquelle Q weitestgehend nicht störend wirken. Solche nicht idealen Komponenten der Signalstromquelle Q können dabei aufgrund einer ladungsträger- und raumladungsabhängigen ohmsch-kapazitiv wirkenden Eigenschaft, die die nutzbare Bandbreite einengt, gegeben sein.

Der zu dem Verstärkungsrückkoppler D parallel liegende Signalhubbegrenzer E koppelt ab einer einstellbaren Schwelle seinen Steuerstrom über den Ankoppler C so auf den Eingang des Stromverstärkers und Impedanzwandlers A zurück, daß der Spannungshub an den Klemmen der nicht idealen Signalstromquelle Q, der bei größeren Strömen auftritt, begrenzt wird. Dadurch wird eine Übersteuerung vermieden und somit die Auswirkung der nicht idealen Komponenten der Signalstromquelle minimiert.

Der Signalhubbegrenzer E entspricht im Prinzip dem Verstärkungsrückkoppler D mit einer anderen Einsatzschwelle und einer stärkeren Stromrückkopplung, die eine geringere Verstärkung der Schaltung mit sich bringt.

Als dritter Funktionsblock, über den eine Rückkopplung erfolgt, dient der Arbeitspunkteinsteller F zur Stabilisierung und zur Einstellung des Arbeitspunktes der Vorrichtung über den gesamten Temperaturbereich. Eine solche Einheit ist notwendig, da die Vorrichtung aus realen Bauelementen besteht, die temperaturabhängige Kenngrößen aufweisen, so daß Temperatureinflüsse kompensiert werden müssen.

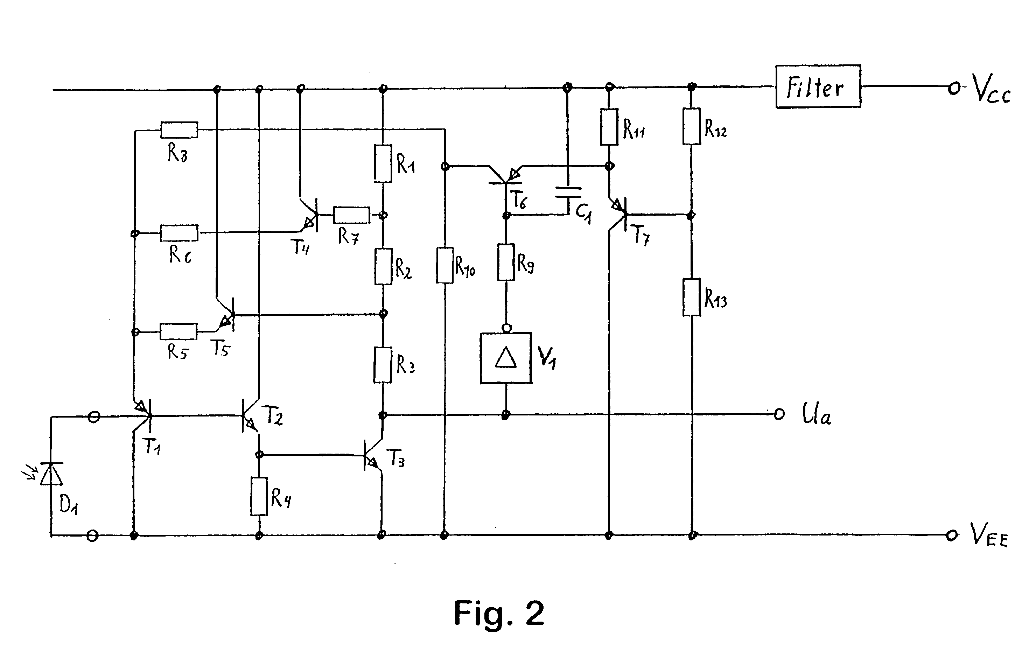

Figur 2 zeigt eine bevorzugte schaltungstechnische Realisierung der einzelnen Funktionsblöcke A,B,C,D,E,F,Q des Ausführungsbeispiels der erfindungsgemäßen Vorrichtung aus Figur 1.

Dabei wird die nicht-ideale Stromquelle Q aus Figur 1 durch eine Fotodiode D1 gebildet.

Der mit der Stromquelle Q verbundene Stromverstärker wird durch einen NPN-Emitterfolger T2 und der Impedanzwandler durch einem Widerstand R4 realisiert.

An den Ausgang des Stromverstärkers A ist ein Spannungsverstärker B angeschlossen, der durch einen einfachen NPN-Transistor T3 in Emitterschaltung realisiert ist und über einen durch Widerstände R1,R2,R3 gebildeten Spannungsteiler verfügt.

Der aus einem PNP-Transistor T1 bestehende Ankoppler C aus Figur 1 ist als rückwärts betriebener Emitterfolger direkt mit seiner Basis auf den Eingang der Vorrichtung geschaltet.

Über dem Widerstand R1 des Spannungsteilers des Spannungsverstärkers B ist über einen Vorwiderstand R7 ein NPN-Transistor T4 in Kollektorschaltung angeschlossen, der über einen weiteren Widerstand R6 mit dem Emitter des Transistors des Ankopplers C verbunden ist.

Für den Signalhubbegrenzer E aus Figur 1 ist zwischen den Widerständen R2 und R3 des Spannungsteilers am Ausgang des Spannungsverstärkers B ein NPN-Transistor T5 direkt in Kollektorschaltung angeschlossen. Der Emitter des Transistors T5 ist über einen Widerstand R5 mit dem Emitter des Transistors des Ankopplers C verbunden.

Für den Funktionsblock Arbeitspunkeinsteller/Temperaturdriftkompensator F aus Figur 1 ist ein invertierender Verstärker V1 an den Kollektor des Transistors T3 des Spannungsverstärkers B gelegt. Der Ausgang des Verstärkers V1 ist seinerseits über einen Tiefpaß R9, C1 mit der Basis eines PNP - Transistors T6 verbunden. Der Kollektor des Transistors T6 ist zum einen mit einem Kollektorwiderstand R10 versehen, zum anderen über einen Widerstand R8 mit dem Emitter des Transistors T1 des Ankopplers C verbunden.

Ein als Hilfsspannungsquelle eingesetzter PNP - Transistor T7 ist mit seiner Basis an einen Spannungsteiler, an dem die Versorgungsspannung Vcc anliegt, zwischen dessen Widerständen R12 und R13 angeschlossen. Der Transistor T7 weist einen Emitterwiderstand R11 auf, der gleichzeitig Emitterwiderstand R11 des Transistors T6 ist.

Die Vorrichtung arbeitet wie folgt:

Die Fotodiode D1 liefert sehr kleine Ströme an den Stromverstärker und Impedanzwandler A. Über den NPN-Emitterfolger T2 wird der Strom verstärkt und durch den Widerstand R4 die Impedanzanpassung an den nachfolgenden stromgesteuerten Spannungsverstärker B durchgeführt.

Der Transistor T3 des Spannungsverstärker B bildet aus dem Strom eine Signalspannung, die er an den Ausgang der Vorrichtung legt und invertiert und verstärkt an den Ausgangswiderständen R1,R2,R3 abbildet.

Der Verstärkungsrückkoppler D speist in Abhängigkeit von der an dem Spannungsteiler des Spannungsverstärkers B anliegenden Spannung über den Widerstand R6 einen Strom in den Eingang des Ankopplers C ein. Der Verstärkungsrückkoppler D bestimmt durch seinen Leitwert den dynamischen, d.h., den durch ein Eingangssignal beeinflußbaren Gleichgewichtszustand der Schaltung, sowie deren Verstärkung. Die Einstellung der Verstärkung der Vorrichtung erfolgt dabei sowohl über den Spannungsteiler R1,R2,R3 als auch über den Vorwiderstand R7. Gleichzeitig bewirkt der Verstärkungsrückkoppler D durch seinen Aufbau eine minimale Belastung des Ausgangssignals und liefert einen leicht zu beherrschenden großen Rückkoppelstrom.

Der Signalhubbegrenzer E ist in seiner Funktion dem Verstärkungsrückkoppler D gleich. Sein Arbeitspunkt wird jedoch so eingestellt, daß er später einsetzt als der Verstärkungsrückkoppler D. Die Verstärkung der Schaltung wird durch den Signalhubbegrenzer E so stark reduziert, daß ein Übersteuern der Schaltung in weiten Grenzen vermieden wird, indem der Transistor T5 bei Überschreiten seiner Basis-Emitter-Spannung über R5 einen Strom in den Eingang des Ankopplers C einspeist.

Der Arbeitspunkteinsteller/Temperaturdriftkompensator F wird für das Einstellen des statischen, daß heißt des nutzsignalunabhängigen Arbeitspunktes für applikationsabhängige Folgeschaltungen, sowie für Ausgleich der Drift dieses Arbeitspunktes durch den Einfluß der Temperatur eingesetzt. Die Berücksichtigung des Temperatureinflusses ist vor allem wegen der in einer Kette liegende Halbleiterübergänge T1, T2, T3, T4, die alle einen in die selbe Richtung wirkende Drift des Arbeitspunktes verursachen, erforderlich.

Für die Festlegung des Arbeitspunktes wird das temperaturabhängige Ausgangssignal Ua des Spannungsverstärkers B invertiert und gemittelt und dieser Mittelwert mit verstärkter Amplitude als Referenz für den Ruhezustand verwendet. Der Arbeitspunkt der Vorrichtung wird dann durch eine temperaturgesteuerte Gleichstromeinkopplung in den Ankoppler der Steuerströme C eingestellt.

Zu diesem Zweck bildet der invertierende Verstärker V1 das Ausgangssignal über den Tiefpaß R9,C1 auf die Basis des Transistors T6 als gemittelte Referenzspannung ab. Die Referenzspannung stellt dann am Kollektorwiderstand R10 eine Gleichspannung ein, die über R8 den für den Gleichgewichtszustand notwendigen Strom in den Ankoppler C einspeist. Zur Kompensation des Temperatureinflusses des Transistors T6 wird an seinem Emitter, das heißt an dem Widerstand R11, von dem Transistor T7 entsprechend der Einstellung des Spannungsteilters R12/R13 eine Hilfsspannung zur Verfügung gestellt.

Die auf den Eingang der Vorrichtung einzuspeisenden kleinen Steuerströme werden, durch die Blöcke D,E,F verstärkt, über die Widerstände R5,R6,R8 auf den Emitter des PNP-Transistors T1 gelegt und mit dem Reziprokwert 1/B der Stromverstärkung B des Transistors T1 auf den Eingang abgebildet. Dadurch wird zudem erreicht, daß alle störenden parasitären Kapazitäten mit großen Strömen schnell umgeladen werden und alle störenden Ströme sich nur noch mit dem Reziprokwert 1/B der Stromverstärkung des Transistors T1 auf den empfindlichen Eingang auswirken können.

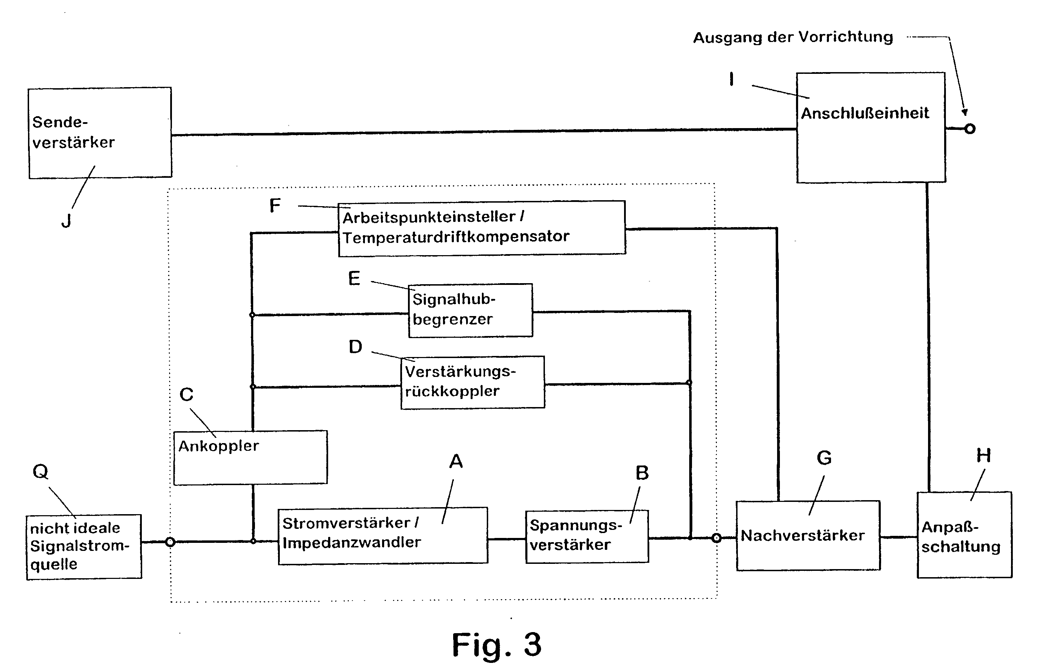

Ein zweites Ausführungsbeispiel, bei dem die Vorrichtung für eine "10 Base T" Applikation einsetzbar sein soll, ist als Blockschaltbild in Figur 3 dargestellt.

Über die Funktionsblöcke aus Figur 1 hinaus, weist das Ausführungsbeispiel aus Figur 3 hintereinander angeordnet einen Nachverstärker G, eine Anpaßschaltung H und eine Anschlußeinheit I auf. Dabei ist der Nachverstärker G mit dem Ausgang des Spannungsverstärkers verbunden und die Anschlußeinheit I mit dem Ausgang der gesamten Vorrichtung und damit in diesem Fall mit einer "10 Base T"-Applikation. Die Anschlußeinheit I ist zusätzlich noch mit einem Sendeverstärker J verbunden. Im Unterschied zu Figur 1 erfolgt hier eine Rückkopplung über einen Arbeitspunkteinsteller/Temperaturkompensator F nicht direkt von dem Ausgangs des Spannungsverstärkers aus, sondern erst von einem Ausgang des Nachverstärkers G aus.

Die Funktionsweise der Blöcke A-F wurde bereits im Zusammenhang mit Figur 1 beschrieben, so daß hier nur auf die Besonderheiten der Ergänzung für "10 Base T" Applikationen eingegangen wird.

"10 Base T" Applikationen nutzen für die Datenübertragung Differenzstromsignale, die an eine strenge Symmetrie gebunden sind (Tastverhältnis, Jitterfreiheit). Desweiteren sind die Betriebsbereitschaft (Link Pulse), der Übertragungsbeginn und das Übertragungsende durch spezielle Signalformen gekennzeichnet. Nach dem Ende jeder Datenübertragung oder jedes Link-Pulses wird die Übertragungsleitung stromfrei geschaltet.

Um ein entsprechendes Signal zur Verfügung stellen zu können, wird das von den Funktionsblöcken A-F gelieferte Spannungssignal zunächst dem Nachverstärker G zugeführt, der an seinem Ausgang ein symmetrisches Signal abbildet, das unabhängig ist von der Amplitude des Eingangssignals. Erreicht wird dies dadurch, daß das Ausgangssignal des Eingangsverstärkers mit einer aus diesem Signal generierten Referenzspannung verglichen wird, die für jede Amplitude des eingespeisten Ausgangssignals Ua auf der Hälfte des Wechselspannungsanteils von Ua liegt.

Das aus dem Nachverstärker G gewonnene symmetrische Differenzspannungssignal wird anschließend einer Anpaßschaltung H zugeführt, die das Differenzspannungssignal über einen Standardtreiber in ein Differenzstromsignal umsetzt. Dabei wird das zum Betreiben eines Standardtreibers notwendige Steuersignal ausschließlich aus dem Differenzspannungssignal des Nachverstärkers G gewonnen.

Für "10 Base T" Applikationen gibt es zwei verschiedene Beschaltungen, eine für einen Anschluß an einen PC und einen anderen für einen Anschluß an einen Netzverteiler (HUB). Die beiden Anschlußbeschaitungen unterscheiden sich lediglich darin, daß die Ein- und Ausgänge vertauscht sind. Das in der Anpaßschaltung H an "10 Base T" Anwendungen angepaßte Differenzstromsignal wird an eine universelle Anschlußeinheit gelegt, die sowohl einen Anschluß für eine Verbindung zu einem PC als auch einen Anschluß für eine Verbindung zu einem Netzverteiler aufweist, so daß das notwendige Tauschen von Ein- und Ausgängen beim Anschluß an einen PC oder an einen Netzverteiler durch einfaches Umstecken der Anschlußleitung erfolgen kann.

Für den Einsatz der Vorrichtung an eine "10 Base T" Applikation ist des weiteren ein Sendeverstärker J für den Betrieb eines Lichtemitters, wie eine LED, notwendig. Dieser wandelt das Differenzeingangssignal der "10 Base T" Applikation in einen Sendestrom für den Lichtemitter um. Wenn kein Differenzeingangssignal anliegt, schaltet der Sendeverstärker J den Sendestrom ab, da es sich in einem solchen Fall um einen nicht definierten Zustand handelt.

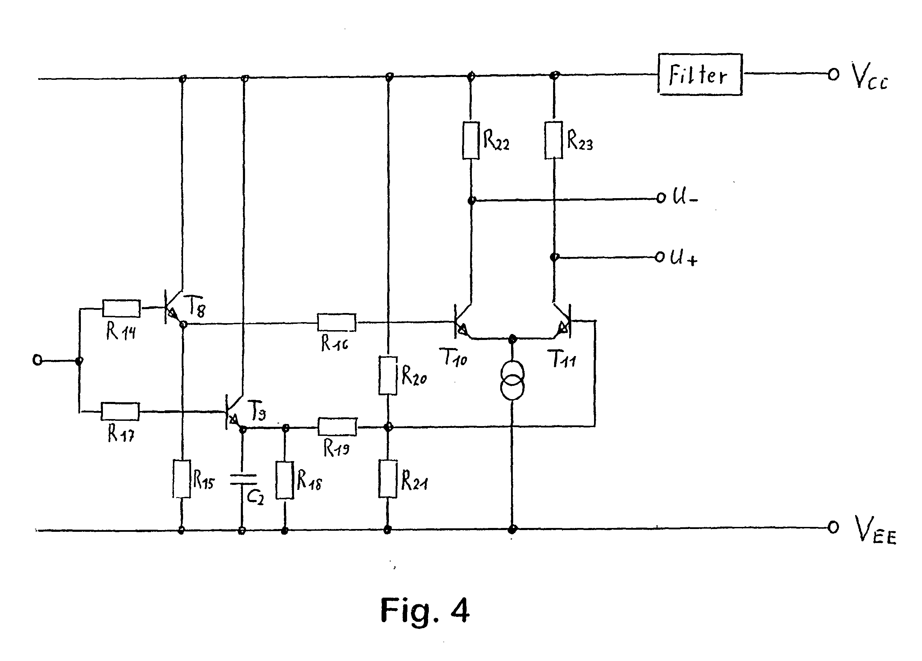

Mögliche schaltungstechnische Realisierungen der einzelnen Funktionsblöcke sind in den Figuren 4-7 dargestellt.

Figur 4 zeigt eine Ausführung eines Nachverstärkers G mit Symmetrierungseinrichtung.

Der Ausgang des Spannungsverstärkers B aus Figur 3 ist in dem Nachverstärker G zum einen mit einer ersten Emitterfolgerschaltung R14,T8,R16 und zum anderen mit einer zweiten Emitterfolgerschaltung R17,T9,R18 verbunden. Die erste Emitterfolgerschaltung ist über ihren Widerstand R16 mit dem invertierenden Eingang eines Differenzverstärkers mit Transistoren T10,T11 verbunden. Parallel zu dem Widerstand R18 der zweiten Emitterfolgerschaltung ist ein Kondensator C2 geschaltet. Der Emitter des Transistors T9 der zweiten Emitterfolgerschaltung ist über einen Spannungsteiler R19,R20,R21 an den nicht invertierenden Eingang des Differenzverstärkers gelegt.

Das von dem Spannungsverstärker B gelieferte Spannungssignal wird über die beiden Emitterfolgerschaltungen entkoppelt. Ein erstes Signal wird über den Widerstand R16 direkt auf den invertierenden Eingang des Differenzverstärkers T10/T11 gelegt. Mittels der zweiten Emitterfolgerschaltung wird zudem ein Referenzsignal für die Symmetrisierung der Spannung gewonnen. Für die Bildung dieses Referenzsignals lädt sich die Kapazität C2 auf den erreichten Maximalwert der Signalspannung auf, der in Abhängigkeit von den Widerständen R18 bis R21 gehalten wird (Spitzenwertdetektion). Über den Spannungsteiler R19,R20,R21 wird die Spannung am Kondensator C2 so geteilt, daß die Ausgangsspannung des Teilers über dem Widerstand R21 des Spannungsteilers immer auf der Hälfte des Wechselspannungsanteils der Signalspannung am invertierenden Eingang des Differenzverstärkers T10/T11 liegt. Das erzeugte Referenzsignal wird dann an den nicht invertierenden Eingang des Differenzverstärkers T10/T11 gelegt.

Zwischen den Kollektoren des Transistors T10 und des Transistors T11 liegt somit ein Differenzspannungssignal an, das das Ausgangsignal des Nachverstärkers G bildet, wobei die Ausgangsspannung des Spannungsverstärkers B nachverstärkt ist und am Differenzspannungsausgang unabhängig von der Signalamplitude der Ausgangsspannung des Spannungsverstärkers B ein symmetrisches Signal mit einem Tastverhältnis von annähernd 1:1 abgebildet wird.

Das erhaltene Differenzspannungssignal eignet sich damit direkt zur Weiterverarbeitung über Standard - Differenzspannungsverstärker.

Der invertierende Verstärker V1, der in Figur 2 eingezeichnet ist, kann alternativ auch in dem Nachfolgeverstärker G integriert sein.

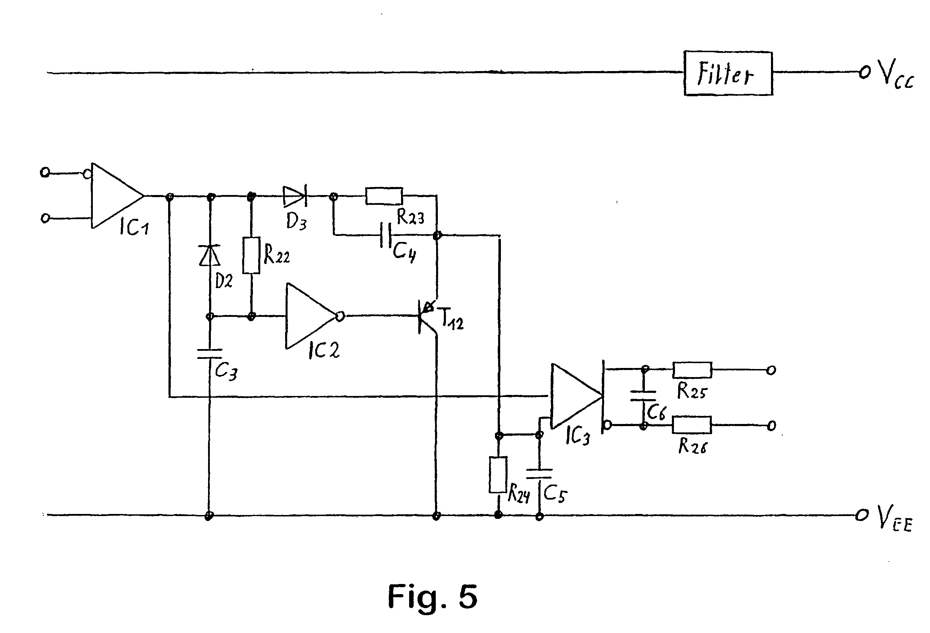

In Figur 5 ist eine Ausführung einer Anpaßschaltung H auf "10 Base T" Applikationen mit Steuerlogik dargestellt.

Der Differenzspannungsausgang des Nachverstärkers G ist am Eingang der Anpaßschaltung H mit einem IC1 verbunden. Der Ausgang des IC1 ist auf den Signaleingang eines Treiberbausteins IC3 gelegt. Zusätzlich ist der Ausgang des IC1 über eine Diode D3 und eine Parallelschaltung eines Widerstandes R23 und eines Kondensators C4 als Einschalt-Beschaltung mit dem Steuereingang des Treiberbausteins IC3 verbunden. An dem Steuereingang des Treiberbausteins IC3 ist ferner eine Parallelschaltung aus einem Widerstand R24 und einem Kondensator C5 vorgesehen.

Eine Abschalt-Beschaltung für den Treiberbaustein IC3 wird von einem Transistor 12 gebildet, der über ein invertierendes Gatter IC2 mit einer Diode D2, einem Widerstand R22 und einem Kondensator C3 verbunden ist.

Der Ausgang des Treiberbausteins IC3 ist mit einer Beschaltung aus einem Kondensator C6 und Widerständen R25,R26 versehen, die den Ausgang der Anpaßschaltung H bildet.

Die Anpassung des Differenzspannungssignals des Nachfolgeverstärkers G an die für "10 Base T" Applikationen notwendigen Differenzstromsignale erfolgt über Standardtreiber. Das für die Freigabe, also das Aufheben und Wiederherstellen des hochohmigen Zustandes (Tri-State) vor und nach einer Datenübertragung notwendige Steuersignal wird ebenfalls aus dem Differenzspannungssignal des Nachfolgeverstärkers G gewonnen.

Zu diesem Zweck wird das Differenzspannungssignal aus dem Nachverstärker G über IC1 in ein TTL-Signal gewandelt, welches direkt auf den Signaleingang des Treiberbausteins IC3 geschaltet wird. Der Steuereingang von IC3 ist über D3, C4 und R23 so mit dem TTL-Ausgangssignal von IC1 beschaltet, daß der logische Zustand "1" sofort die Differenzstromausgänge von IC3 in den niederohmigen Zustand schaltet. Über die Elemente R24 und C5 ist eine Zeit eingestellt, um sicherstellen zu können, daß der Treiberbaustein IC3 auch im logischen Zustand "0" während der Datenübertragung sicher nicht "ausschaltet". Erst nach länger anliegendem logischen Zustand "0" ist der Kondensator C5 soweit entladen, daß IC3 in den hochohmigen Zustand zurückfällt.

Um ein sicheres Abschalten von IC3 am Ende einer Übertragung zu gewährleisten muß der Treiber IC3 auch bei länger anliegendem logischen Zustand "1" nach definierter Zeit abgeschaltet werden. Dies wird dadurch erreicht, daß nach der mit R22 und C3 eingestellten Zeit das invertierende Gatter IC2 auf logisch "0" schaltet und somit über T12 der Treiberbaustein IC3 abgeschaltet wird. D2 dient zur Entladung von C3.

Die Beschaltung des Treiberbausteins IC3 mit C6, R25 und R26 dient zur Anpassung der Differenzausgänge des Treibers IC3 an den "10 Base T" Anschluß.

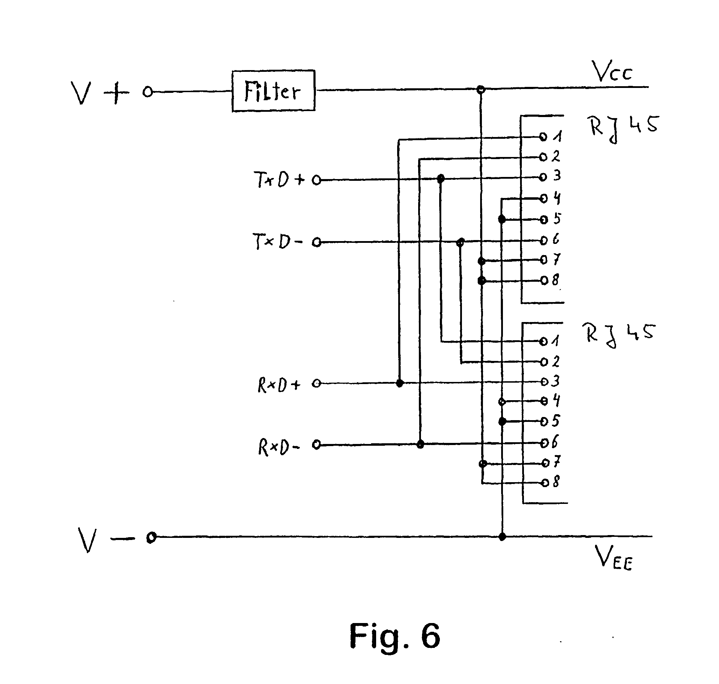

Figur 6 zeigt eine bevorzugte Ausführung einer Anschlußeinheit I aus Figur 3.

Die Anschlußeinheit I verfügt über zwei RJ45-Steckanschlüsse, die jeweils acht Anschlüsse 1-8 aufweisen. Die Anschlüsse 4,5,7,8 sind bei beiden Steckanschlüssen an die Spannungs-versorgungsleitungen der Vorrichtung angeschlossen. Die Anschlüsse 1 und 2 des ersten Steckanschlusses und die Anschlüsse 3 und 6 des zweiten Steckanschlusses sind mit dem Ausgang der Anpaßschaltung H aus Figur 3 verbunden. Der Eingang des Sendeverstärkers J aus Figur 3 ist genau umgekehrt mit den Steckanschlüssen verbunden, d.h. mit den Anschlüssen 3 und 6 des ersten Steckanschlusses und den Anschlüssen 1 und 2 des zweiten Steckanschlusses.

Für den universellen Einsatz der erfindungsgemäßen Vorrichtung durch Verbindung mit vorhandenen RJ45-Anschlüssen müssen zwei Anschlußarten zur Verfügung stehen, und zwar eine für den Anschluß an einen PC und eine andere für den Anschluß an einen Netzverteiler. Die beiden Anschlußarten unterscheiden sich nur dadurch, daß die Beschaltung der Ein- und Ausgänge am RJ45 jeweils vertauscht sind. In dem Ausführungsbeispiel aus Figur 6 sind zwei RJ45-Anschlüsse vorgesehen, die so miteinander verschaltet sind, daß durch einfaches Umstecken der RJ45-Anschlußleitung an der Vorrichtung die Ein- und Ausgänge vertauscht werden.

Der jeweils freie RJ45-Anschluß wird darüber hinaus dazu genutzt, die erfindungsgemäße Vorrichtung über die von "10 Base T" Applikationen nicht genutzten Anschlüsse 4, 5, 7 und 8 mit der zum Betrieb notwendigen Energie zu versorgen. Der Anschluß erfolgt dabei über ein Netzteil mit einem RJ45-Stecker, ohne daß ein zusätzlicher Versorgungsspannungseingang vorgesehen werden muß.

In der Anschlußeinheit aus Figur 6 ist die Verbindung zu der positiven Versorgungsspannung an den Anschlüssen 7 und 8 und die Verbindung zum Massepotential an den Anschlüssen 4 und 5 beider RJ45-Anschlüsse vorgesehen. Alle anderen Variationen für eine Verbindung der freien Anschlüsse 4, 5, 7 und 8 für das Anschließen der Versorgungsspannung sind ebenso möglich.

Die Versorgung der einzelnen Schaltungseinheiten erfolgt jeweils über Filter, um Störungen auf der Versorgungsspannung innerhalb und außerhalb der Vorrichtung zu unterdrücken.

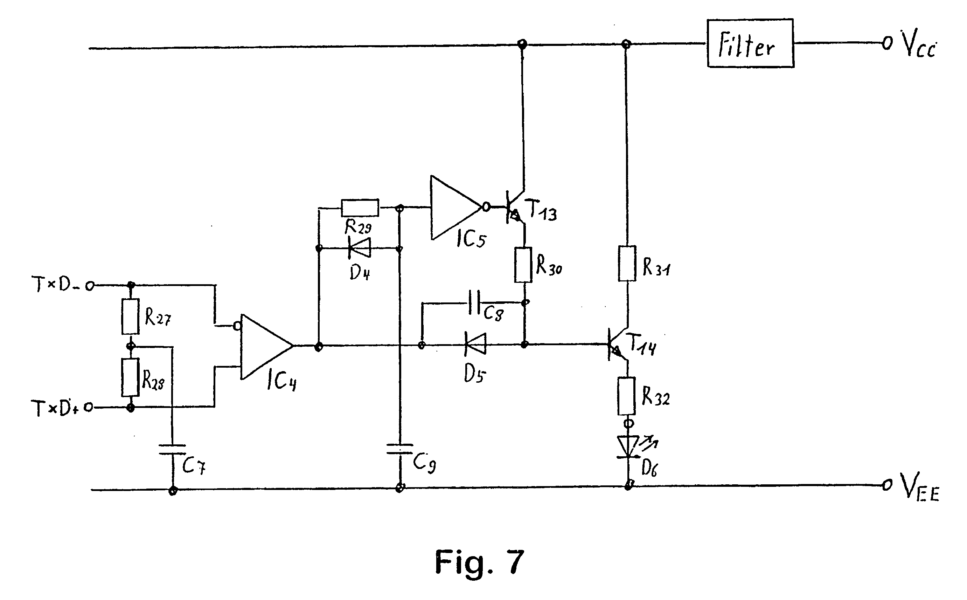

Schließlich ist in Figur 7 eine schaltungstechnische Realisierung des Sendeverstärkers J aus Figur 3 dargestellt.

Nach Außen ist der Sendeverstärkers J an seinem Eingang mit den entsprechenden Anschlüssen der RJ45-Steckanschlüsse der Anschlußeinheit I aus Figur 6 verbunden. Innerhalb des Sendeverstärkers J ist der Eingang über Widerstände R27,R28 und einen Kondensator C7 auf den Eingang eines Standardbausteins IC4 gelegt.

Der Ausgang des IC4 liegt über die Parallelschaltung einer Diode D5 und eines Kondensator C8 an der Basis eines Schalttransistors T14 an. Der Schalttransistors T14 ist an seinem Kollektor mit einem Widerstand R31 und an seinem Emitter mit einem in Reihe mit einem weiteren Widerstand R32 geschalteten Emitter D6 verbunden.

Mit einem Widerstand R29, einer Diode D4, einem Kondensator C9 und einem invertierenden Gatter IC5 ist zusammen mit einem Emitterfolger T13,R30 eine Zeitschaltung an dem Ausgang des IC4 vorgesehen. Dabei ist der Emitterfolger T13,R30 ebenfalls mit der Basis des Schalttransistors T14 verbunden.

Der Sendeverstärker J mit Abschaltautomatik dient dazu, das Differenz-Eingangssignal einer "10 Base T" Applikation in einen für den Betrieb eines Lichtemitters (LED) notwendigen Strom zu wandeln. Gleichzeitig trägt er dafür Sorge, daß bei Nichtvorhandensein eines Differenz-Eingangssignals aufgrund einer abgeschalteten bzw. nicht angeschlossenen Applikation der Lichtemitter ausgeschaltet wird. Diese Abschaltautomatik ist notwendig, da beim Einsatz von Standardbausteinen für die Umwandlung des Differenz-Eingangssignals in ein TTL-Signal das Nichtvorhandensein eines Differenz-Eingangssignals am TTL-Ausgang zu nicht definierten Zuständen führt.

Die Auskopplung des Differenzeingangssignals einer "10 Base T" Applikation erfolgt über den mit R27, R28 und C7 beschalteten Standardbaustein IC4. Der TTL-Ausgang des IC4 steuert über D5 und C8 die Basis des Schalttransistors T14 und somit über R31 und R32 den zum Betrieb des Emitters D6 notwendigen Strom. Im normalen Betriebsfall erhält die Basis von T14 ihren positiven Strom über den Emitterfolger T13 und R30. Schaltet jedoch im nicht definierten Zustand der TTL-Ausgang von IC4 auf logisch "l", so fällt nach einer durch R29 und C9 einstellbaren Zeit der Ausgang des invertierenden Gatters IC5 auf logisch "0", so daß über T13 der Basisstrom abgeschaltet wird. Über D4 wird dieser Abschaltzustand mit der ersten logischen "0" am TTL-Ausgang von IC4 umgehend aufgehoben.

## Patentansprüche

1. Vorrichtung zum Umsetzen kleiner, von einer nicht-idealen Stromquelle (Q) an dem Eingang der Vorrichtung eingeprägter Ströme in Spannungssignale, enthaltend einen Umsetzer (A,B) zum Wandeln der kleinen Ströme in Spannungssignale
**dadurch gekennzeichnet, daß** der Ausgang des Umsetzers (A,B) über mindestens einen Rückkoppelzweig (D,E,F) und einen Ankoppler (C) auf den Eingang des Umsetzers (A, B) rückgekoppelt ist, wobei der Ankoppler (C) so geschaltet ist, daß von dem mindestens einen Rückkoppelzweig (D,E,F) gelieferte Steuerströme zur Steuerung der kleinen, von der nicht idealen Stromquelle (Q) an dem Eingang der Vorrichtung eingeprägten Ströme an dem Eingang des Umsetzers (A,B) mittels des Ankopplers (C) unter einer Minderung des kapazitiven, induktiven und ohmschen Einflusses der Rückkoppelzweige sowie einer Amplitudenanpassung der Steuerströme einkoppelbar sind.

2. Vorrichtung nach Anspruch 1,
**dadurch gekennzeichnet, daß** der Umsetzer einen Stromverstärker und Impedanzwandler (A) sowie einen Spannungsverstärker (B) umfaßt.

3. Vorrichtung nach Anspruch 2,
**dadurch gekennzeichnet, daß** einer der Rückkoppelzweige einen Verstärkungsrückkoppler (D) zur Einstellung der Verstärkung des Spannungsverstärkers (B) und zur Kompensation von Auswirkungen nicht-idealer Komponenten der Stromquelle im Eingangsstrom umfaßt.

4. Vorrichtung nach einem der voranstehenden Ansprüche,
**dadurch gekennzeichnet, daß** einer der Rückkoppelzweige einen Arbeitspunkteinsteller (F) zur Einstellung des Arbeitspunktes der Vorrichtung mit Temperaturdriftkompensation umfaßt zum Ausgleichen von Temperatureinflüssen auf die eingesetzten Bauteile.

5. Vorrichtung nach Anspruch 3 oder 4,
**dadurch gekennzeichnet, daß** einer der Rückkoppelzweige einen Signalhubbegrenzer (E) zur Reduzierung der Verstärkung der Vorrichtung und zur Begrenzung des Signalhubs am Eingang der Vorrichtung umfaßt, wobei die Schwelle für den Einsatz der Wirkung des Signalhubbegrenzers (E) so liegt, daß sie später als der Verstärkungsrückkoppler (D) einsetzt.

6. Vorrichtung nach Anspruch 5,
**dadurch gekennzeichnet, daß** die Einsatzschwelle des Signalhubbegrenzers (E) einstellbar ist.

7. Vorrichtung nach einem der voranstehenden Ansprüche,
**dadurch gekennzeichnet, daß** der Ankoppler (C) einen Transisor (T1) umfaßt, insbesondere einen PNP-Transistor geschaltet als rückwärts betriebener Emitterfolger, dessen Basis auf den Eingang des Umsetzers (A, B) geschaltet ist.

8. Vorrichtung nach einem der voranstehenden Ansprüche,
**dadurch gekennzeichnet, daß** die nicht-ideale Stromquelle (Q) durch eine Fotodiode gebildet wird.

9. Vorrichtung nach.einem der voranstehenden Ansprüche,
**dadurch gekennzeichnet, daß** die einzelnen Funktionsblöcke Umsetzer (A,B), Ankoppler (C) sowie die in den Rückkopplungszweigen eingesetzten Schaltungen wie Verstärkungsrückkoppler (D), Signalhubbegrenzer (E) und/oder Arbeitspunkteinsteller (F) NPN-, PNP- oder Feldeffekt-Transistoren oder Kombinationen hieraus umfassen.

10. Verwendung einer Vorrichtung nach einem der voranstehenden Ansprüche für verschiedene Anwendungen bei entsprechender Ergänzung, insbesondere für "10 Base T"-, "100 Base T"-, Gigabase-, Profibus- und Interbus-Anwendungen.

11. Vorrichtung nach einem der Ansprüche 1-9,
**dadurch gekennzeichnet, daß** für eine Verwendung mit einer "10 Base T"-Applikation der Ausgang des Umsetzers (A,B) über
- einen Nachverstärker (G) mit einem Differenzspannungsausgang für die Ausgabe eines symmetrischen Signals,
- eine Anpaßschaltung auf "10 Base T"-Applikationen (H) zur Umsetzung des Differenzspannungssignals in ein Differenzstromsignal und
- eine Anschlußeinheit (I) auf RJ45-Basis mit Anschlußmöglichkeit an einen PC oder einen Netzverteiler,
mit dem Ausgang der Vorrichtung verbunden ist, wobei die Anschlußeinheit (I) zusätzlich mit einem Sendeverstärker verbunden ist, zur Wandlung eines Differenzeingangssignals der "10 Base T"-Applikation in einen Sendestrom für einen Lichtemitter.

12. Vorrichtung nach Anspruch 11,
**dadurch gekennzeichnet, daß** ein zur Arbeitspunkteinstellung mit Temperaturdriftkompensation eingesetzter Arbeitspunkteinsteller (F) nicht direkt von dem Ausgang des Spannungsverstärkers (B), sondern erst von dem Ausgang des Nachverstärkers (G) über den Ankoppler (C) auf den Eingang des Umsetzers (A,B) rückgekoppelt ist.

13. Vorrichtung nach einem der Ansprüche 11 oder 12,
**dadurch gekennzeichnet, daß** der Sendeverstärker (J) Mittel zur automatischen Abschaltung bei nicht eingeschalteter bzw. nicht angeschlossener "10 Base T" Applikation aufweist.

14. Vorrichtung nach einem der Ansprüche 11 oder 13,
**dadurch gekennzeichnet, daß** die Anschlußeinheit I mindestens zwei RJ45-Steckanschlüsse aufweist, von denen für die "10 Base T" Applikation nicht benötigten Anschlüsse (4,5,7,8) mit Spannungsversorgungsleitungen der Vorrichtung verbunden sind, zum Ermöglichen einer Spannungsversorgung der Vorrichtung über den jeweiligen für die "10 Base T" Applikation nicht eingesetzten Steckanschluß.

## Claims

1. A device for converting low currents applied by a non-ideal current source (Q) to the input of the device into voltage signals, comprising a converter (A, B) for converting the low current into a voltage signal,
**characterized in that** the output of the converter (A, B) is fed back to the input of the converter (A, B) over at least one feedback branch (D, E, F) and a coupler (C), with the coupler (C) being wired so that control currents supplied by the minimum of one feedback branch (D, E, F) can be applied to the input of the converter (A, B) by means of the coupler (C) to control the low currents applied by the non-ideal current source (Q) to the input of the device, with a reduction in the capacitive, inductive and ohmic influence of the feedback branches and with amplitude matching of the control currents.

2. A device according to Claim 1,
**characterized in that** the converter comprises a current amplifier and impedance converter (A) and an inverting voltage amplifier (B).

3. A device according to Claim 2,
**characterized in that** one of the feedback branches comprises a gain feedback device (D) for adjusting the gain of the voltage amplifier (B) and for compensation of effects of non-ideal components of the current source in the input current.

4. A device according to one of the preceding claims,
**characterized in that** one of the feedback branches comprises a working point adjuster (F) for adjusting the working point of the device with temperature drift compensation for compensation of temperature effects on the components used.

5. A device according to Claim 3 or 4,
**characterized in that** one of the feedback branches comprises a signal stroke limiter (E) for reducing the gain of the device and for limiting the signal stroke at the input of the device, with the threshold for use of the effect of the signal stroke limiter (E) being such that it starts later than the gain feedback device (D).

6. A device according to Claim 5,
**characterized in that** the starting threshold of the signal stroke limiter (E) can be adjusted.

7. A device according to one of the preceding claims,
**characterized in that** the coupler (C) comprises a transistor (T1), in particular a PNP transistor wired as a reverse operated emitter follower whose base is connected to the input of the converter (A, B).

8. A device according to one of the preceding claims,
**characterized in that** the non-ideal current source (Q) is formed by a photodiode.

9. A device according to one of the preceding claims,
**characterized in that** the individual function blocks, the converters (A, B), the coupler (C) and the circuits used in the feedback paths, such as the gain feedback device (D), signal stroke limiter (E) and/or working point adjuster (,F) comprise NPN transistors, PNP transistors, field effect transistors or combinations hereof.

10. A use of a device according to one of the preceding claims
for various applications with appropriate supplementation, in particular for 10 base T applications, 100 base T applications, gigabase applications, profibus and interbus applications.

11. A device according to one of Claims 1 through 9,
**characterized in that** for use with a 10 base T application, the output of the converter (A, B) is connected over
• a post-amplifier (G) to a differential voltage output for output of a symmetrical signal,
• an adaptor circuit for 10 base T applications (H) for converting the differential voltage signal into a differential current signal and
• a terminal unit (I) for RJ45 base with the option of connection to a PC or a network distributor,
to the output of the device, where the terminal unit (I) is also connected to a transmission amplifier, for conversion of a differential input signal of the 10 base T application to a transmission current for a light emitter.

12. A device according to Claim 11,
**characterized in that** a working point adjuster (F) used for adjusting the working point with temperature drift compensation is not connected back to the input of the converter (A, B) directly from the output of the voltage amplifier (B) but instead is connected back only from the output of the post-amplifier (G) over the coupler (C).

13. A device according to one of Claims 11 or 12,
**characterized in that** the transmission amplifier (J) has means for automatic shutdown when the 10 base T application is not connected or is not running.

14. A device according to one of Claims 11 or 13,
**characterized in that** the terminal unit (I) has at least two RJ45 terminal connections, of which the terminals (4, 5, 7, 8) not needed for the 10 base T application are connected to power supply lines of the device to permit a power supply to the device over the respective terminal connection not used for the 10 base T application.

## Revendications

1. Dispositif de conversion en signaux de tension, de faibles courants appliqués par une source de courant non idéale (Q) à l'entrée du dispositif, comprenant un convertisseur (A, B) pour convertir les faibles courants en signaux de tension, **caractérisé en ce que** la sortie du convertisseur (A, B) est réinjectée via au moins une branche de réinjection (D, E, F) et un élément de couplage (C) à l'entrée du convertisseur (A, B), l'élément de couplage (C) étant branché de sorte que des courants de commande délivrés par la au moins une branche de réinjection (D, E, F) pour commander les faibles courants appliqués par la source de courant non idéale (Q) à l'entrée du dispositif puissent être injectés à l'entrée du convertisseur (A, B) au moyen de l'élément de couplage (C) en réduisant l'influence capacitive, inductive et ohmique des branches de réinjection ainsi qu'en adaptant l'amplitude des courants de commande.

2. Dispositif selon la revendication 1, **caractérisé en ce que** le convertisseur comprend un amplificateur de courant et un convertisseur d'impédance (A) ainsi qu'un amplificateur de tension (B).

3. Dispositif selon la revendication 2, **caractérisé en ce que** l'une des branches de réinjection comprend un réinjecteur d'amplification (D) pour régler l'amplification de l'amplificateur de tension (B) et pour compenser les effets de composants non idéaux de la source de courant dans le courant d'entrée.

4. Dispositif selon l'une quelconque des revendications précédentes, **caractérisé en ce que** l'une des branches de réinjection comprend un régulateur de point de fonctionnement (F) pour régler le point de fonctionnement du dispositif avec compensation de la dérive en température afin de compenser les influences de la température sur les composants utilisés.

5. Dispositif selon la revendication 3 ou 4, **caractérisé en ce que** l'une des branches de réinjection comprend un limiteur de déviation du signal (E) pour réduire l'amplification du dispositif et pour limiter la déviation du signal à l'entrée du dispositif, le seuil d'intervention de l'effet du limiteur de déviation du signal (E) étant tel qu'il intervienne plus tard que le réinjecteur d'amplification (D).

6. Dispositif selon la revendication 5, **caractérisé en ce que** le seuil d'intervention du limiteur de déviation du signal (E) est réglable.

7. Dispositif selon l'une quelconque des revendications précédentes, **caractérisé en ce que** l'élément de couplage (C) comprend un transistor (T1), en particulier un transistor PNP connecté en émetteur-suiveur commandé en sens inverse, dont la base est connectée à l'entrée du convertisseur (A, B).

8. Dispositif selon l'une quelconque des revendications précédentes, **caractérisé en ce que** la source de courant non idéale (Q) est formée par une photodiode.

9. Dispositif selon l'une quelconque des revendications précédentes, **caractérisé en ce que** les blocs fonctionnels individuels, à savoir le convertisseur (A, B), l'élément de couplage (C), ainsi que les circuits utilisés dans les branches de réinjection, tels que le réinjecteur d'amplification (D), le limiteur de déviation du signal (E) et/ou le régulateur de point de fonctionnement (F) comprennent des transistors NPN, PNP ou à effet de champ ou des combinaisons de ceux-ci.

10. Utilisation d'un dispositif selon l'une quelconque des revendications précédentes pour diverses applications dans le cas d'un complément correspondant, en particulier pour des applications "10 base T", "100 base T", Gigabase, Profibus et Interbus.

11. Dispositif selon l'une quelconque des revendications 1 à 9, **caractérisé en ce que**, pour une utilisation avec un application "10 Base T", on connecte la sortie du convertisseur (A, B) via
- un post-amplificateur (G) avec une sortie de tension différentielle pour la délivrance d'un signal symétrique,
- un circuit d'adaptation à des applications "10 Base T" (H) pour convertir le signal de tension différentiel en un signal de courant différentiel, et
- une unité de connexion (I) à base RJ45 avec une possibilité de connexion à un PC ou à un distributeur de réseau,
à la sortie du dispositif, l'unité de connexion (I) étant connectée en outre à un amplificateur d'émission, pour convertir un signal d'entrée différentiel de l'application "10 Base T" en un courant d'émission pour un photo-émetteur.

12. Dispositif selon la revendication 11, **caractérisé en ce qu'**un régulateur de point de fonctionnement (F) utilisé pour le réglage du point de fonctionnement avec compensation de la dérive en température n'est pas réinjecté directement par la sortie de l'amplificateur de tension (B), mais seulement par la sortie du post-amplificateur (G) à l'entrée du convertisseur (A, B) via l'élément de couplage (C).

13. Dispositif selon l'une quelconque des revendications 11 ou 12, **caractérisé en ce que** l'amplificateur d'émission (J) présente des moyens pour se déconnecter automatiquement lorsque l'application "10 Base T" n'est pas enclenchée, respectivement pas connectée.

14. Dispositif selon l'une quelconque des revendications 11 ou 13, **caractérisé en ce que** l'unité de connexion I présente au moins deux connexions d'enfichage RJ45, dont les connexions qui ne sont pas nécessaires à l'application "10 Base T" (4, 5, 7, 8) sont raccordées à des lignes d'alimentation en tension du dispositif pour permettre une alimentation en tension du dispositif via la connexion d'enfichage respective non utilisée pour l'application "10 Base T".
